# EUROPÄISCHE PATENTSCHRIFT

(11) **EP 0 635 838 B1**
(45) Veröffentlichungstag und Bekanntmachung des Hinweises auf die Patenterteilung: **14.04.1999**
(21) Anmeldenummer: 94109986.3
(22) Anmeldetag: 28.06.1994
(51) Int. Cl.: G11C 5/14, G11C 11/407, G11C 8/00

(54) **Spannungserzeugungsschaltung**
Voltage generation circuit
Circuit de génération de tension

(30) Priorität: 23.07.1993 DE 4324853
(43) Veröffentlichungstag der Anmeldung: 25.01.1995
(73) Patentinhaber: SIEMENS AKTIENGESELLSCHAFT, 80333 München (DE)
(72) Erfinder: Savignac, Dominique, Dr. rer. nat., D-85737 München (DE); Gleis, Dieter, Dr. Ing., D-83109 Grosskarolinenfeld (DE); Menke, Manfred, D-80799 München (DE)

(56) Entgegenhaltungen:
- EP-A- 0 535 325
- DE-A- 4 117 882
- US-A- 5 184 035

## Beschreibung

Die Erfindung bertrifft eine Schaltung zur Erzeugung einer weiteren Spannung aus einer Versorgungsspannung.

Die weitere Spannung kann dabei größer oder kleiner als die Versorgungsspannung sein. Solche Spannungserzeugungsschaltungen werden bei integrierten Schaltungen häufig verwendet, um bestimmte Schaltungsteile mit einer Betriebs-oder Steuerspannung zu versorgen, die von der Versorgungsspannung der integrierten Schaltung abweicht. Beispielsweise kann bei dynamischen Halbleiterspeichern (DRAMs) mit einer Speicherzelle, die einen Auswahltransistor und eine Speicherkapazität enthält, der Auswahltransistor ein n-Kanal-MOS-Transistor sein. Um die zu speichernde Information sicher schreiben zu können, muß die Ansteuerspannung einer Wortleitung, durch die der Gate-Anschluß des Auswahltransistors gesteuert wird, über der Versorgungsspannung liegen. Aus Gründen der Zuverlässigkeit darf diese erhöhte Spannung außerdem einen maximalen Wert nicht übersteigen. Schaltungen zur Spannungserzeugung werden auch verwendet, wenn Schaltungen beispielsweise aus Gründen der Standardisierung von einer festgelegten Versorgungsspannung (z.B. 5 Volt) gespeist werden, die internen Schaltungen jedoch bei einer reduzierten Betriebsspannung (z.B. 3,3 Volt) betrieben werden.

Zur Erzeugung der erhöhten Wortleitungsspannung bei DRAMs sind Booster-Schaltungen bekannt, die nach dem Prinzip der Ladungsverschiebung arbeiten. Die hohe Spannung wird mittels Schiebekapazitäten erzeugt, die in der Ruhephase des DRAMs vorgeladen werden. Solche Booster haben jedoch den Nachteil, daß die Schiebekapazitäten bei jedem Arbeitszyklus vollständig be- und entladen werden. Da die erhöhte Spannung im schwankungsbereich der Versorgungsspannung sicher erzeugt werden muß, sind die Schiebekapazitäten für die untere Grenze des Schwankungsbereichs auszulegen. Sie sind deshalb relativ groß und verbrauchen somit eine hohe Leistung. Die Begrenzung der maximalen Wortleitungsspannung für eine Versorgungsspannung am oberen Schwankungsbereich erfordert außerdem komplizierte Schaltungen.

In der Veröffentlichung "An Experimental 1.5-V 64-Mb DRAM", Nakagome, Y. et al, IEEE Journal of Solid-State Circuits, Band 26, Nr. 4, April 1991 wird zur Erzeugung der erhöhten Spannung eine Ladungspumpe verwendet. Die Wortleitungen werden in der Lese- bzw. Schreibphase durch Ladungstranfer aus der Speicherkapazität geladen und mit einem kleineren zweistufigen Ladungsschieber auf den erhöhten Pegel gebracht. Dabei sind keine Maßnahmen gezeigt, mit denen die maximale Spannung begrenzt werden könnte.

Die Aufgabe der vorliegenden Erfindung ist es, eine Schaltung zur Erzeugung einer weiteren Spannung aus einer Versorgungsspannung anzugeben, bei der die weitere Spannung unabhängig von Schwankungen der Versorgungsspannung erzeugt wird. Die Schaltung soll dabei zuverlässig im Schwankungsbereich der Versorgungsspannung arbeiten und eine geringe Leistung verbrauchen.

Diese Aufgabe wird durch die Merkmale des Patentanspruchs 1 gelöst.

Vorteilhafte Weiterbildungen der Spannungserzeugungsschaltung sind in den Unteransprüchen angegeben. Zur Erzeugung einer über der Versorgungsspannung liegenden Ausgangsspannung kann eine Ladungspumpe verwendet werden. Zur Erzeugung einer reduzierten Ausgangsspannung kann ein aktiv geregelter MOS-Transistor verwendet werden. Die erste Komparatoreinrichtung weist zweckmäßigerweise eine geringe Verzögerungszeit auf und ist abschaltbar. Da schnelle Komparatorschaltungen üblicherweise eine relativ hohe Leistung verbrauchen, ist vorgesehen, daß diese während einer inaktiven Phase abgeschaltet wird. Die zweite Komparatoreinrichtung nat zweckmäßigerweise eine relativ große Verzögerungszeit, verbraucht dafür aber eine geringe Leistung und bleibt ständig eingeschaltet. Somit ist eine verlustleistungssparende Betriebsweise möglich.

Die Komparatoreinrichtungen sind derart ausgeführt, daß ihre eingangsseitige Vergleichsstufe mit einer Referenzspannung versorgt wird. Dadurch ist eine von Schwankungen der Versorgungsspannung der integrierten Schaltung unabhängige Vergleichsschwelle einstellbar.

Die Erfindung wird im folgenden anhand der in den Figuren gezeigten Ausführungsbeispiele näher erläutert. Es zeigen
Figur 1 das Prinzipschaltbild einer Schaltung zur Erzeugung einer erhöhten Spannung,
Figur 2a, 2b ein Zeitdiagramm relevanter Signale,
Figur 3a, 3b die Realisierung des ersten Komparators und ein zugehöriges statisches Kennliniendiagramm,
Figur 4 die Realisierung des zweiten Komparators,
Figur 5 einen Flankendetektor und
Figur 6 eine Schaltung zur Erzeugung einer reduzierten Spannung.

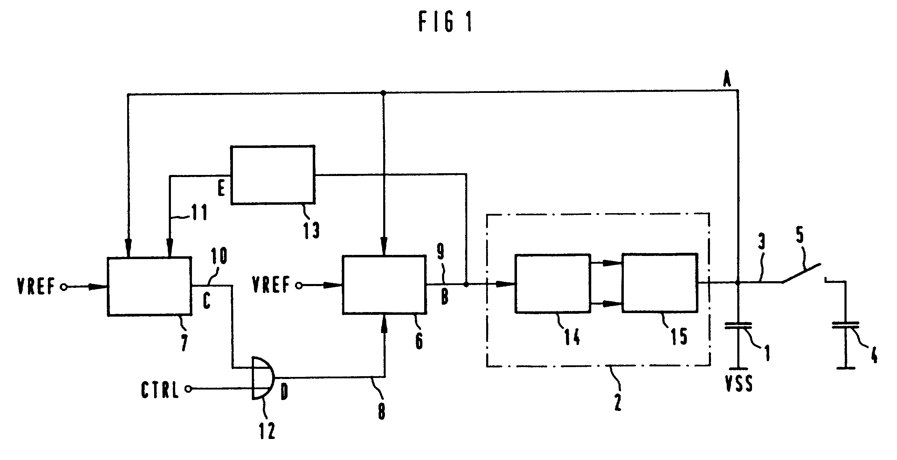

Zur Erzeugung der erhöhten Spannung wird in der Figur 1 eine Ladungspumpe 2 verwendet, mit der eine Speicherkapazität 1 aufgeladen wird. Eine Elektrode der Speicherkapazität 1 liegt auf Bezugspotential VSS (Masse), die andere Elektrode 3 ist mit einem Ausgang der Ladungspumpe 2 verbunden. Die in der Figur 1 gezeigte Schaltung ist insbesondere zur Erzeugung der erhöhten Wortleitungssignalspannung bei DRAMs geeignet. Die Speicherkapazität 1 besteht dabei im wesentlichen aus der Wannenkapazität des Wortleitungspfades. Sie braucht deshalb nicht als weitere Kapazität auf den Chip realisiert zu werden. Während der aktiven Schreib-oder Lesephase werden eine oder mehrere ausgewählte Wortleitungen mit der erhöhten Spannung aus der Speicherkapazität 1 gespeist. Dies ist in der Figur 1 dadurch dargestellt, daß der die erhöhte Spannung führende Anschluß 3 der Speicherkapazität 1 über einen Schalter 5 mit der wirksamen Kapazität 4 der ausgewählten Wortleitungen verbunden wird. Als Ladungspumpe kann jede Ladungspumpe verwendet werden, die abschaltbar ist. Als vorteilhaft hat sich eine Ladungspumpe erwiesen, die einen abschaltbaren Oszillator 14 enthält, der die zur Steuerung der Pumpschaltung 15 notwendigen periodischen Signale erzeugt. Die Pumpschaltung 15 kann zweckmäßigerweise aus zwei identischen Hälften aufgebaut werden, die im Gegentaktbetrieb gesteuert werden.

Die Ausgangsspannung A am Anschluß 3 wird einem ersten Komparator 6 und einem zweiten Komparator 7 zugeführt. Die Ausgangsspannung A wird in den Komparatoren 6, 7 mit je einer Vergleichsschwelle verglichen. Dabei liegt die Vergleichsschwelle des Komparators 6 etwas höher als die Vergleichsschwelle des Komparators 7. Um die Vergleichsschwelle von der Versorgungsspannung unabhängig einzustellen wird den Komparatoren 6, 7 eine Referenzspannung VREF zugeführt. Die Komparatoren 6, 7 erzeugen an ihren Ausgängen 9 bzw. 10 einen logischen H-Pegel, wenn die zu vergleichende Spannung unterhalb der jeweiligen Vergleichsschwelle liegt, und einen L-Pegel, wenn die zu vergleichende Spannung oberhalb der Vergleichsschwelle liegt. Der Komparator 6 ist derart dimensioniert, daß er eine geringe Schaltverzögerung aufweist. Deshalb verbraucht er eine relativ hohe Verlustleistung. Über einen Steuereingang 8 kann der Komparator 6 und somit dessen Leistungsverbrauch abgeschaltet werden. Der Komparator 7 verbraucht wenig Verlustleistung, so daß seine Schaltverzögerung relativ groß ist. Über einen Steuereingang 11 ist der Komparator 7 rücksetzbar. Der Ausgang 10 des Komparators 7 ist mit dem Steuereingang 8 des Komparators 6 verbunden. Über eine logische Verknüpfung 12, hier zweckmäßigerweise eine ODER-Verknüpfung, wird ein Steuerungssignal CTRL an den Steuereingang 8 des Komparators 6 gekoppelt. Der Ausgang 9 des Komparators 6 ist über einen Flankendetektor 13 mit dem Steuereingang 11 des Komparators 7 verbunden. Mit dem Ausgang 9 des Komparators 6 wird die Ladungspumpe 2 ein- und ausgeschaltet.

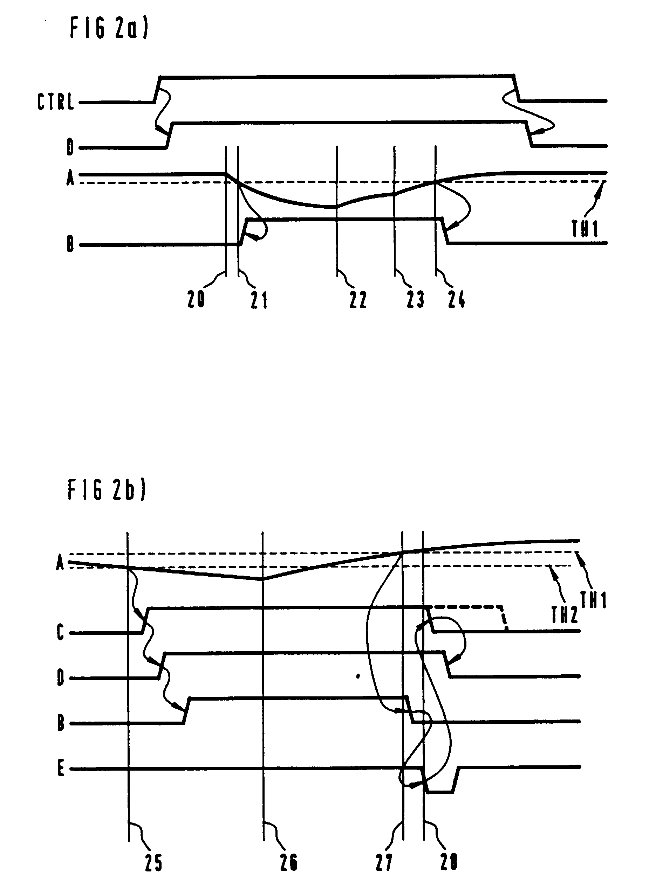

Die Funktionsweise der in der Figur 1 gezeigten Schaltung wird im folgenden unter Verwendung der in der Figur 2 dargestellten Signaldiagramme beschrieben. Die Betriebsabläufe sind bei einer aktiven Schreib- bzw. Lesephase und der Ruhephase verschieden. Die aktive Phase wird durch einen H-Pegel des Signals CTRL angegeben, das im DRAM zeitrichtig zur Steuerung des Schalters 5 erzeugt wird. Während dieser Phase ist der Ladungsabfluß aus der Speicherkapazität 1 in die Wortleitungskapazität 4 möglichst rasch auszugleichen. Die entsprechenden Signale sind in der Figur 2a gezeigt. Während der Ruhephase führen im wesentlichen Leckströme zu einem Spannungsabfall an der Speicherkapazität 1. Auch dieser Spannungsabfall wird ausgeglichen, damit beim Beginn einer aktiven Phase die volle erhöhte Spannung zur Verfügung steht. Die Signalabfolge zum Ausgleich dieses Spannungsabfalls ist in Figur 2b gezeigt.

Während einer aktiven Schreib- oder Lesephase (Figur 2a) wird durch das Signal CTRL und über das Ausgangssignal D des ODER-Schaltglieds 12 der Komparator 6 eingeschaltet. Zum Zeitpunkt 20 beginnt der Ladungstransfer aus der Speicherkapazität 1 zur Wortleitungskapazität 4. Die Ausgangsspannung A am Anschluß 3 fällt ab und unterschreitet zum Zeitpunkt 21 die Schaltschwelle TH1 des Komparators 6. Der Komparator 6 nat eine geringe Verzögerungszeit, so daß unmittelbar nach dem Zeitpunkt 21 das Ausgangssignal B des Komparators 6 aktiv wird. Dadurch wird die Ladungspumpe 2 eingeschaltet. Durch die Ladungspumpe wird z.B. mit zwei Pumptakten zu den Zeitpunkten 22, 23 die Ausgangsspannung A erhöht, bis sie am Zeitpunkt 24 die Schaltschwelle TH1 des Komparators 6 überschreitet. Daraufhin wird das Ausgangssignal B des Komparators 6 auf L rückgesetzt, wodurch die Ladungspumpe 2 abgeschaltet wird. Zum Zeitpunkt 24 ist auch der Ladungstransfer der Speicherkapazität 1 zur Wortleitungskapazität 4 bereits beendet, so daß die Ausgangsspannung A beim vorliegenden Pegel erhalten bleibt. Das Verhältnis von Speicherkapazität 1 zu Wortleitungskapazität 4 wird bei den üblichen DRAMs mit 5 Volt Versorgungsspannung derart eingestellt, daß die Spannung A nach einem vollständigen Ladungsausgleich höchstens um 0,5 Volt sinken würde. Damit kann ein Zugriff auf den Speicher sofort nach dem Beginn der aktiven Phase eingeleitet werden. Zur Wiederherstellung des erhöhten Pegels der Ausgangsspannung A steht die Pumpe für die Dauer der gesamten aktiven Phase zur Verfügung. Sie kann deshalb relativ klein dimensioniert werden, so daß große störende Stromspitzen vermieden werden.

Während der Ruhephase des DRAMs (Figur 2b) ist der Komparator 6 durch den L-Pegel des Signals CTRL normalerweise ausgeschaltet. Dadurch wird die Leistungsaufnahme der Gesamtschaltung reduziert. Der Komparator 7 ist dauernd eingeschaltet. Er verbraucht eine geringe Leistung, weist dafür aber eine im Vergleicn zum Komparator 6 größere Verzögerungszeit auf. Die Schaltschwelle TH2 des Komparators 7 liegt etwas unter der Schaltschwelle TH1 des Komparators 6.

Aufgrund von Leckströmen sinkt die Ausgangsspannung A und unterschreitet zum Zeitpunkt 25 die Schaltschwelle TH2 des Komparators 7. Nach der Verzögerungszeit des Komparators 7 wird dessen Ausgangssignal C aktiv. Dadurch wird über das Signal D der Komparator 6 eingeschaltet. Da die Schaltschwelle TH1 des Komparators 6 über der Schaltschwelle TH2 des Komparators 7 liegt, wird auch das Ausgangssignal B des Komparators 6 aktiv geschaltet. Die Ladungspumpe 2 wird eingeschaltet und beginnt zum Zeitpunkt 26 einen Pumptakt. Wenn die Ausgangsspannung A die Schaltschwelle TH1 des Komparators 6 zum Zeitpunkt 27 überschreitet, wird das Ausgangssignal B des Komparators 6 auf L umgeschaltet. Die Ladungspumpe 2 wird dadurch abgeschaltet. Aufgrund des langsameren Schaltverhaltens des Komparators 7 bleibt dessen Ausgangssignal C weiterhin auf H, obwohl das Ausgangssignal A jetzt über dessen Schaltschwelle TH2 liegt. Damit der Komparator 6, der einen hohen Stromverbrauch aufweist, schnell abgeschaltet werden kann, wird die fallende Flanke des Ausgangssignals B des Komparators 6 im Flankendetektor 13 festgestellt. Dabei wird im Ausgangssignal E des Flankendetektors 13 vom Zeitpunkt 28 an ein Impuls zum Rücksetzen des Komparators 7 erzeugt. Die Impulsdauer wird so gewählt, daß interne Knoten des Komparators 7 sicher abgeschaltet werden, so daß dessen Ausgangssignal C auf L rückgesetzt wird. Dadurch wird auch das Signal D rückgesetzt, so daß der Komparator 6 ausgeschaltet wird, um die Leistungsaufnahme zu verringern. Das Signal E ist im Ausführungsbeispiel L-aktiv, das heißt, der vom Flankendetektor 13 erzeugte Impuls hat einen L-Pegel. Wenn keine Flanke erkannt wird, liegt das Signal E auf einem H-Pegel.

Je nach Empfindlichkeit und Verzögerungszeit der Komparatoren 6, 7 liegt die erhöhte Ausgangsspannung A nahe der Schaltschwellen TH1 bzw. TH2 der Komparatoren. Für den Zweck der dynamischen Regelung im DRAM ist eine Regelbreite von 0,2 Volt ausreichend. Die Ladungspumpe 2 ist derart dimensioniert, daß sie an der unteren Schwankungsgrenze der Versorgungsspannung den notwendigen Pegel für die erhöhte Spannung A während einer aktiven Phase nach vorzugsweise zwei Pumptakten erreicht.

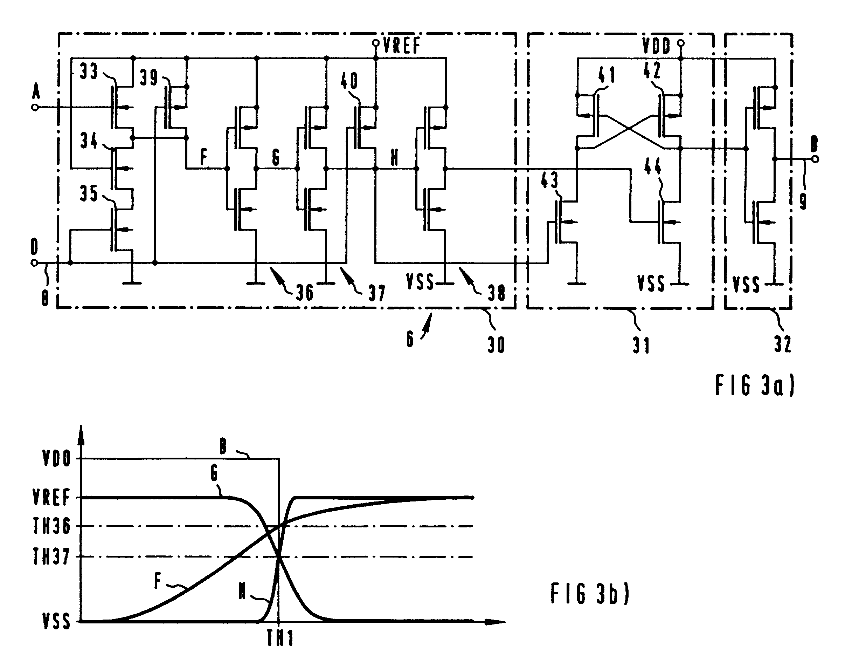

Eine schaltungstechnische Realisierung für den Komparator 6 ist in Figur 3a zusammen mit statischen Kennlinien in Figur 3b gezeigt. Der Komparator enthält eingangsseitig eine Vergleichsstufe 30, die vom Bezugspotential VSS und vom Referenzpotential VREF versorgungsspannungsseitig gespeist wird. Der Vergleichsstufe 30 ist eine Pegelumsetzungseinrichtung 31 nachgeschaltet, die vom Bezugspotential VSS und vom Versorgungspotential VDD versorgt wird. Das Ausgangssignal des Pegelumsetzers 31 wird in einer Verstärkerstufe 32 verstärkt.

Die Vergleichsstufe 30 ist im einzelnen folgendermaßen aufgebaut: Sie enthält eingangsseitig drei mit ihren Drain-Source-Strecken in Reihe geschaltete MOS Transistoren 33, 34, 35, die zwischen den Potentialen VREF und VSS liegen. Der Transistor 33 wird vom Signal A gesteuert, der Transistor 35 vom Signal D und der Transistor 34 vom Potential VREF. An den Verbindungspunkt der Transistoren 33, 34 ist ein Inverter 36 angeschlossen, dem zwei weitere Inverter 37, 38 nachgeschaltet sind. Die Schaltschwelle TH37 des Inverters 37 liegt niedriger als die Schaltschwelle TH36 des Inverters 36. Vorzugsweise liegt die Schaltschwelle TH37 etwa in der Mitte zwischen den Potentialen VREF, VSS. Zwischen den Eingängen der Inverter 36, 38 und dem Referenzpotential VREF ist je ein p-Kanal-MOS-Transistor 39, 40 geschaltet, der vom Signal D gesteuert wird.

Der Pegelumsetzer 31 ist ein kreuzgekoppelter Pegelkonverter mit zwei zwischen die Versorgungspotentiale VDD und VSS geschalteten Strompfaden, die je einen n- und einen p-Kanal-MOS-Transistor enthalten. Die p-Kanal-MOS-Transistoren 41, 42 sind auf der Seite des Versorgungspotentials VDD angeordnet und kreuzgekoppelt. Die n-Kanal-MOS-Transistoren 43, 44 werden von komplementären Signalen gesteuert, nämlich den Ausgangssignalen der Inverter 37 bzw. 38. Ausgangsseitig ist dem Pegelumsetzer 31 als Verstärkerstufe 32 ein Inverter nachgeschaltet. Der Inverter 32 wird von der gleichen Versorgungsspannung wie der Pegelumsetzer 31 gespeist. Der Ausgang des Inverters 32 ist der Ausgang 9 des Komparators 6, der das Signal B führt. Vorzugsweise wird die Vergleichsstufe 30 von einer separaten, ungestörten Versorgungspotentialquelle VSS gespeist, die von der Versorgungspotentialquelle VSS für den Pegelumsetzer 31 und die Verstärkerstufe 32 unabhängig ist. Durch das ruhige Potential VSS und das von Schwankungen der Versorgungsspannung VSS, VDD unabhängige Referenzpotential VREF kann ein relativ genauer Vergleich des Signals A mit der Schaltschwelle TH1 des Komparators 6 erreicht werden.

Der Komparator 6 ist durch das Signal D ein- und ausschaltbar. Wenn das Signal D einen L-Pegel führt, ist der Transistor 35 gesperrt, die Transistoren 39, 40 sind leitend. Dadurch ist der Eingangsstrompfad aus den Transistoren 33, 34, 35 ausgeschaltet. Durch die Transistoren 39, 40 wird das Ausgangssignal B des Komparators 6 auf einen L-Pegel eingestellt. Führt das Signal D einen H-Pegel, ist der Transistor 35 leitend, die Transistoren 39, 40 sind unwirksam. Im Eingangsstrompfad der Transistoren 33, 34, 35 fließt nun ein Querstrom. Der Transistor 34 wirkt dabei als Widerstand. Der Pegel des Signals F am Eingang des Inverters 36 ist von der Aussteuerung des Transistors 33 durch das Signal A abhängig (Figur 3b). Wenn bei ansteigendem Signal A das Signal F die Schaltschwelle TH36 des Inverters 36 überschreitet, schalten die Inverter 36, 37, 38 jeweils in ihren komplementären Zustand um. Die H- und L-Pegel der Signale G, H liegen jeweils bei den Potentialen VREF bzw. VSS. Diese Signalpegel werden durch den Pegelumsetzer 31 auf H- und L-Pegel bei den Potentialen VDD bzw. VSS umgesetzt. Die Inverter 36, 37, 38 und der Pegelumsetzer 31 bewirken eine Verstärkung des Signals F. Durch die Dimensionierung der Schaltschwellen TH36, TH37 bezüglich des Signals F kann die Schaltschwelle TH1 des Komparators 6 eingestellt werden.

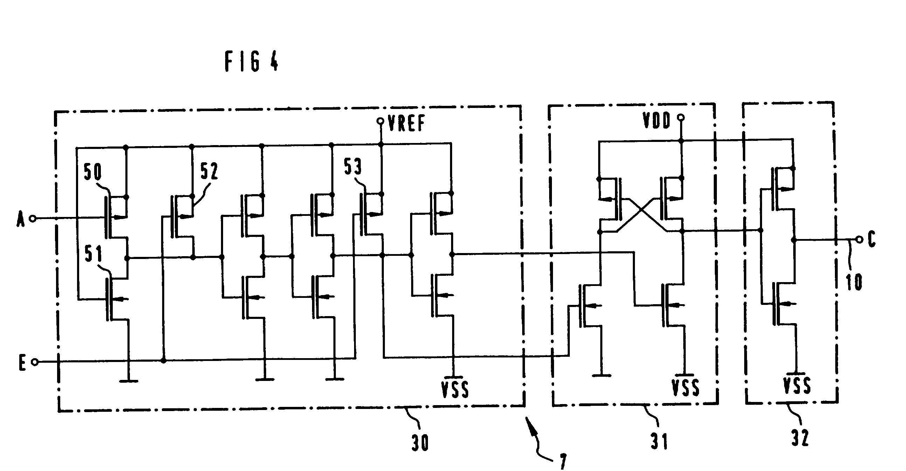

Der Komparator 7 hat im Vergleich zum Komparator 6 eine geringere Leistungsaufnahme. Er ist nicht abschaltbar, aber durch das Signal E rücksetzbar. Die schaltungstechnische Realisierung des Komparators 6 in der Figur 4 entspricht im wesentlichen der Schaltung der Figur 3a, wobei der Eingangsstrompfad der Vergleichsstufe nur zwei mit den Drain-Source-Strecken in Reihe geschaltete n-Kanal-MOS- Transistoren 50, 51 enthält. Der an das Referenzpotential VREF angeschlossene Transistor 50 wird vom Signal A gesteuert, der bezugspotentialseitig angeschlossene Transistor 51 wirkt als Widerstand. Dieser Strompfad ist nicht abschaltbar. Eine geringe Leistungsaufnahme mittels eines geringen Querstroms wird durch die entsprechende Dimensionierung der Transistoren 50, 51 erreicht. Durch einen L-Pegel des Signals E werden p-Kanal-MOS-Transistoren 52, 53 leitend gesteuert und verbinden die entsprechenden Signalleitungen mit dem Potential VREF. Dadurch wird das Signal C am Ausgang 10 des Komparators 7 auf einen L-Pegel rückgesetzt. Die Höhe der Vergleichsschwelle des Komparators 7 wird entsprechend dem Komparator 6 durch die relative Dimensionierung der Schaltschwellen der verwendeten Inverter zum Ausgangssignal des Eingangsstrompfades eingestellt.

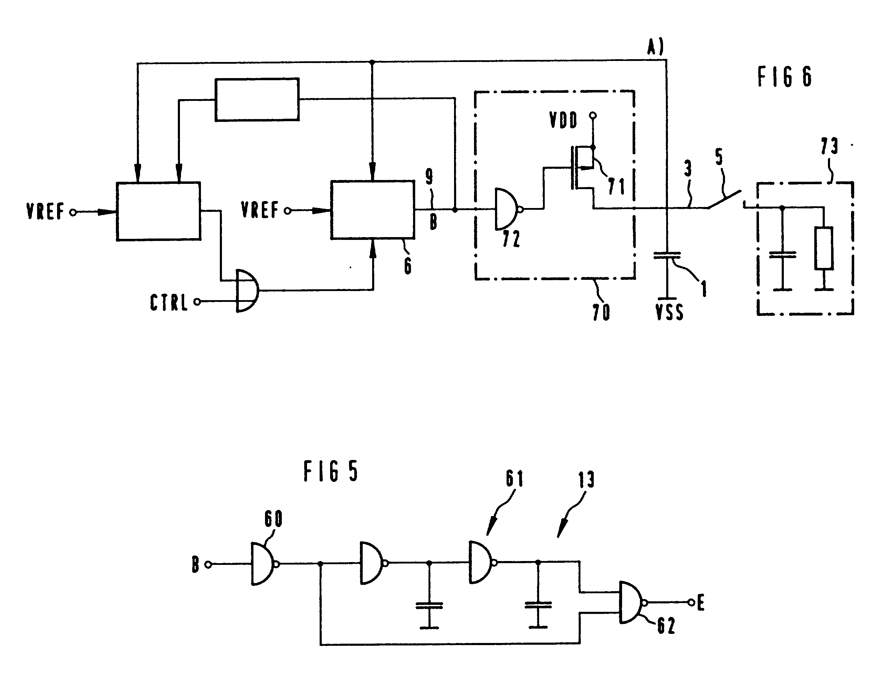

Die Realisierung des Flankendetektors 13 erfolgt in einer dem Fachmann bekannten Weise. Eine zweckmäßige Realisierungsmöglichkeit ist in Figur 5 gezeigt. Das Signal B wird einem Inverter 60 zugeführt, dessen Ausgangssignal sowohl über eine Verzögerungsstrecke 61 als auch unverzögert einem NICHT-UND-Schaltglied 62 zugeführt wird. Beim Auftreten einer Flanke von H nach L des Signals B tritt dann am Ausgang des NICHT-ODER-Schaltgliedes 62 ein negativ gerichteter Impuls auf, dessen Länge im wesentlichen durch die Verzögerungszeit längs der Verzögerungsstrecke 61 bestimmt wird. Bei einer positiv gerichteten Flanke des Signals B bleibt das Ausgangssignal E des Flankendetektors 13 im Ruhezustand H.

Die bisherigen Ausführungen betreffen eine Schaltung zur Erzeugung einer erhöhten, über der Versorgungsspannung liegenden Ausgangsspannung. Diese wird beispielsweise bei DRAM-Bausteinen zur Ansteuerung der Wortleitungen verwendet. In der Schaltung der Figur 1 wird deshalb als spannungserzeugungseinricntung eine Ladungspumpe 2 angesteuert. Die Schaltung der Figur 6 enthält als Spannungserzeugungseinrichtung 70 einen p-Kanal-MOS-Transistor 71. Die Drain-Source-Strecke des Transistors 71 ist zwischen das Versorgungspotential VDD und die Speicherkapazität 1 geschaltet. Der Transistor 71 wird vom Ausgangssignal B des Komparators 6 phasenrichtig über einen Inverter 72 angesteuert. Der Ausgang 3 der Spannungserzeugungsschaltung führt eine Spannung A' bezüglich Bezugspotential VSS, die kleiner ist als die Versorgungsspannung VSS, VDD. Mit dem Ausgang 3 ist über einen Schalter 5 eine Last 73 verbunden. Die Last 73 kann sowohl kapazitive als auch ohmsche Lastanteile haben. Dies bedeutet, daß mit der Schaltung der Figur 6 am Ausgang 3 auch ein Gleichstrom geliefert werden kann. Eine solche Schaltung zur Erzeugung einer reduzierten Spannung wird vorteilhafterweise zur Versorgung von Schaltungseinheiten in DRAM-Bausteinen verwendet, die mit einer unter der Versorgungsspannung liegenden Betriebsspannung versorgt werden. Dadurch können die Bauelemente dieser Schaltungsteile für eine geringere Betriebsspannung dimensioniert werden. Außerdem wird Verlustleistung gespart.

Das Funktionsprinzip der in der Figur 6 gezeigten Schaltung entspricht im wesentlichen dem der Schaltung der Figur 1. Während der Ruhephase wird die Speicherkapazität 1 über den p-Kanal-MOS-Transistor 71 bis zur Vergleichsspannung TH1 des Komparators 6 aufgeladen. Die Vergleichsspannung TH1 des Komparators 6 liegt nun unterhalb des Versorgungspotentials VDD. Bei der aktiven Phase wird über den Schalter 5 die Last 73 aus der Speicherkapazität 1 versorgt. Wenn die Spannung A' am Ausgang 3 unter die Schwellspannung TH1 des nun eingeschalteten Komparators 6 fällt, wird der Transistor 71 leitend gesteuert. Der erforderliche Ladestrom fließt solange, bis die Spannung A' die Schaltschwelle des Komparators 6 erreicht hat und der Transistor 71 gesperrt wird.

## Patentansprüche

1. Spannungserzeugungsschaltung mit
(a) einer Speicherkapazität (1) mit einem Anschluß (3) zum Abgriff einer Ausgangsspannung (A),
(b) einer Spannungserzeugungseinrichtung (2, 70), die ein-und ausschaltbar ist, und die einen Ausgang aufweist, der mit dem Anschluß (3) der Speicherkapazität (1) verbunden ist,
(c) einer ersten Komparatoreinrichtung (6), die ein- und ausschaltbar ist und durch die die Ausgangsspannung (A) mit einer ersten Schwellenspannung verglichen wird, so daß ein Signal (B) zum Ein- und Ausschalten der Spannungserzeugungseinrichtung (2) erzeugt wird,
(d) einer zweiten Komparatoreinrichtung (7), durch die die Ausgangsspannung (A) mit einer zweiten Schwellenspannung verglichen wird, so daß ein Ausgangssignal (C) erzeugt wird, mit dem die erste Komparatoreinrichtung (6) ein- und ausgeschaltet wird.

2. Spannungserzeugungsschaltung nach Anspruch 1, **dadurch gekennzeichnet**, daß das Ausgangssignal (C) der zweiten Komparatoreinrichtung (7) mit einem Steuerungssignal (CTRL) mittels eines logischen Verknüpfungsgliedes (12) verknüpft wird, und daß durch das Ausgangssignal (D) des logischen Verknüpfungsgliedes (12) die erste Komparatoreinrichtung (7) ein- und ausgeschaltet wird.

3. Spannungserzeugungsschaltung nach Anspruch 1 oder 2, **dadurch gekennzeichnet**, daß die erste Komparatoreinrichtung (6) eine geringere Signalverzögerungszeit als die zweite Komparatoreinrichtung (7) hat, daß die zweite Schwellenspannung kleiner ist als die erste Schwellenspannung und daß das Ausgangssignal (B) der ersten Komparatoreineinrichtung einem Flankendetektor (13) zugeführt wird, der bei einer die Spannungserzeugungseinrichtung (2, 60) ausschaltenden Signalflanke einen Impuls erzeugt, durch den die zweite Komparatoreinrichtung (7) rückgesetzt wird.

4. Spannungserzeugungsschaltung nach Anspruch 3, **dadurch gekennzeichnet**, daß jeder Komparator jeweils enthält:
(a) eine Vergleichsstufe (30), die von einem Referenzpotential (VREF) und einem ersten Versorgungspotential (VSS) versorgt wird,
(b) eine Pegelumsetzeinrichtung (31), die vom ersten Versorgungspotential (VSS) und einem zweiten Versorgungspotential (VDD) versorgt wird und durch die die Ausgangssignalpegel der Vergleichsstufe (30) auf eines der Versorgungspotentiale (VDD, VSS) umgesetzt werden und
(c) eine Verstärkerstufe (32), die einem Ausgang der Pegelumsetzungseinrichtung (31) nachgeschaltet ist.

5. Spannungserzeugungsschaltung nach Anspruch 4, **dadurch gekennzeichnet**, daß die Vergleichsstufe (30) enthält:
(a) einen ersten n-Kanal-MOS-Transistor (33; 50), dessen Drain-Anschluß mit dem Referenzpotential (VREF) verbunden ist und dessen Gate-Anschluß von der Ausgangsspannung (A) gesteuert wird,
(b) einen zweiten n-Kanal-MOS-Transistor (34; 51), dessen Drain-Source-Strecke zwischen den Source-Anschluß des ersten n-Kanal-MOS-Transistors (33; 50) und das erste Versorgungspotential (VSS) geschaltet ist und dessen Gate-Anschluß mit dem Referenzpotential (VREF) verbunden ist, und
(c) mindestens eine Verstärkerstufe (36), deren Eingang mit dem Source-Anschluß des ersten n-Kanal-MOS-Transistors (33; 50) verbunden ist.

6. Spannungserzeugungsschaltung nach Anspruch 5, **dadurch gekennzeichnet**, daß ein Eingang der Verstärkerstufe (36) über einen p-Kanal-MOS-Transistor (52) mit dem Referenzpotential (VREF) verbunden ist, dessen Gate-Anschluß von einem Signal zum Rücksetzen (D; E) gesteuert wird.

7. Spannungserzeugungsschaltung nach Anspruch 6, **dadurch gekennzeichnet**, daß der zweite n-Kanal-MOS-Transistor (34) der Vergleichsstufe (30) über einen n-Kanal-MOS-Transistor (35) mit dem ersten Versorgungspotential (VSS) verbunden ist, dessen Gate-Anschluß von einem Signal zum Ein- und Ausschalten der Komparatoreinrichtung (D) gesteuert wird.

8. Spannungserzeugungsschaltung nach einem der Ansprüche 1 bis 7, **dadurch gekennzeichnet**, daß die Spannungserzeugungseinrichtung (2) enthält: einen Oszillator (14), der durch ein Signal ein- und auschaltbar ist,
und eine Pumpschaltung (15) die vom Oszillator (14) gesteuert wird.

9. Spannungserzeugungsschaltung nach einem der Ansprüche 1 bis 7, **dadurch gekennzeichnet**, daß die Spannungserzeugungseinrichtung (70) enthält: einen MOS-Transistor (71), dessen Drain-Source-Strecke zwischen das zweite Versorgungspotential (VDD) und den Anschluß (3) der Speicherkapazität geschaltet ist und dessen Gate-Anschluß von dem Ausgangssignal der ersten Komparatoreinrichtung (6) gesteuert wird.

## Claims

1. Voltage generation circuit having
(a) a storage capacitance (1) with a connection (3) to the tap of an output voltage (A),
(b) a voltage generation device (2, 70), which can be switched on and off and has an output connected to the connection (3) of the storage capacitance (1),
(c) a first comparator device (6), which can be switched on and off and by which the output voltage (A) is compared with a first threshold voltage, with the result that a signal (B) for switching the voltage generation device (2) on and off is generated,
(d) a second comparator device (7), by which the output voltage (A) is compared with a second threshold voltage, with the result that an output signal (C) is generated by means of which the first comparator device (6) is switched on and off.

2. Voltage generation circuit according to Claim 1, characterized in that the output signal (C) of the second comparator device (7) is logically combined with a control signal (CTRL) by means of a logic combination element (12), and in that the first comparator device (7) is switched on and off by the output signal (D) of the logic combination element (12).

3. Voltage generation circuit according to Claim 1 or 2, characterized in that the first comparator device (6) has a shorter signal delay time than the second comparator device (7), in that the first threshold voltage is less than the second threshold voltage, and in that the output signal (B) of the first comparator device is fed to an edge detector (13), which generates a pulse in the event of a signal edge that switches the voltage generation device (2, 60) off, which pulse resets the second comparator device (7).

4. Voltage generation circuit according to Claim 3, characterized in that each comparator respectively contains:
(a) a comparison stage (30), which is supplied by a reference potential (VREF) and a first supply potential (VSS),
(b) a level conversion device (31), which is supplied by the first supply potential (VSS) and a second supply potential (VDD) and by which the output signal levels of the comparison stage (30) are converted to one of the supply potentials (VDD, VSS), and
(c) an amplifier stage (32), which is connected downstream of an output of the level conversion device (31).

5. Voltage generation circuit according to Claim 4, characterized in that the comparison stage (30) contains:
(a) a first n-channel MOS transistor (33; 50), whose drain terminal is connected to the reference potential (VREF) and whose gate terminal is controlled by the output voltage (A),
(b) a second n-channel MOS transistor (34; 51), whose drain-source path is connected between the source terminal of the first n-channel MOS transistor (33; 50) and the first supply potential (VSS) and whose gate terminal is connected to the reference potential (VREF), and
(c) at least one amplifier stage (36), whose input is connected to the source terminal of the first n-channel MOS transistor (33; 50).

6. Voltage generation circuit according to Claim 5, characterized in that an input of the amplifier stage (36) is connected to the reference potential (VREF) via a p-channel MOS transistor (52), whose gate terminal is controlled by a signal for resetting (D; E).

7. Voltage generation circuit according to Claim 6, characterized in that the second n-channel MOS transistor (34) of the comparison stage (30) is connected to the first supply potential (VSS) via an n-channel MOS transistor (35), whose gate terminal is controlled by a signal for switching the comparator device (D) on and off.

8. Voltage generation circuit according to one of Claims 1 to 7, characterized in that the voltage generation device (2) contains, an oscillator (14), which can be switched on and off by a signal,
and a pump circuit (15) controlled by the oscillator (14).

9. Voltage generation circuit according to one of Claims 1 to 7, characterized in that the voltage generation device (70) contains:
a MOS transistor (71), whose drain-source path is connected between the second supply potential (VDD) and the connection (3) of the storage capacitance and whose gate terminal is controlled by the output signal of the first comparator device (6).

## Revendications

1. Circuit de production de tension comportant
(a) une capacité (1) de mémoire, comportant une borne (3) pour prélever une tension (A) de sortie,
(b) un dispositif (2, 70) de production de tension, qui peut être connecté et déconnecté et qui comporte une sortie qui est reliée à la borne (3) de la capacité (1) de mémoire,
(c) un premier dispositif (6) comparateur qui peut être connecté et déconnecté et par lequel la tension (A) de sortie est comparée à une première tension de seuil, si bien qu'il est produit un signal (B) pour connecter et déconnecter le dispositif (2) de production de tension,
(d) un deuxième dispositif (7) comparateur par lequel la tension (A) de sortie est comparée à une deuxième tension seuil, si bien qu'il est produit un signal (C) de sortie, par lequel le premier dispositif (6) comparateur est connecté et déconnecté.

2. Circuit de production de tension suivant la revendication 1, caractérisé en ce que le signal (C) de sortie du deuxième dispositif (7) comparateur est couplé à un signal (CTRL) de commande au moyen d'un élément (12) de combinaison logique, et en ce que le premier dispositif (7) comparateur est connecté et déconnecté par le signal (D) de sortie de l'élément (12) de combinaison logique.

3. Circuit de production de tension suivant la revendication 1 ou 2, caractérisé en ce que le premier dispositif (6) comparateur a une durée de retardement de signal inférieure à celle du deuxième dispositif (7) comparateur, en ce que la deuxième tension de seuil est inférieure à la première tension de seuil et en ce que le signal (B) de sortie du premier dispositif comparateur est envoyé à un détecteur (13) de flanc qui, dans le cas d'un flanc de signal déconnectant le dispositif (2, 60) de production de tension, produit une impulsion par laquelle le deuxième dispositif (7) comparateur est remis à l'état initial.

4. Circuit de production de tension suivant la revendication 3, caractérisé en ce que chaque comparateur contient :
(a) un étage (30) comparateur qui est alimenté en un potentiel (VREF) de référence et en un premier potentiel (VSS) d'alimentation,
(b) un dispositif (31) de conversion de niveau qui est alimenté en le premier potentiel (VSS) d'alimentation et en un deuxième potentiel (VDD) d'alimentation et par lequel le niveau du signal de sortie de l'étage (30) comparateur est converti à l'un des potentiels (VDD, VSS) d'alimentation et
(c) un étage (32) amplificateur qui est monté en aval d'une sortie du dispositif (31) de conversion de niveau.

5. Circuit de production de tension suivant la revendication 4, caractérisé en ce que l'étage (30) comparateur contient :
(a) un premier transistor (33 ; 50) MOS à canal n, dont la borne de drain est reliée au potentiel (VREF) de référence et dont la borne de grille est commandée par la tension (A) de sortie,
(b) un deuxième transistor (34 ; 51) MOS à canal n, dont la section drain-source est branchée entre la borne de source du premier transistor (33 ; 50) MOS à canal n et le premier potentiel (VSS) d'alimentation et dont la borne de grille est reliée au potentiel (VREF), et
(c) au moins un étage (36) amplificateur dont l'entrée est reliée à la borne de source du premier transistor (33 ; 50) MOS à canal n.

6. Circuit de production de tension suivant la revendication 5, caractérisé en ce qu'une entrée de l'étage (36) amplificateur est reliée au potentiel (VREF) de référence par l'intermédiaire d'un transistor (52) MOS à canal p, dont la borne de grille est commandée par un signal servant à remettre à l'état initial (D ; E).

7. Circuit de production de tension suivant la revendication 6, caractérisé en ce que le deuxième transistor (34) MOS à canal n de l'étage (30) comparateur est relié au premier potentiel (VSS) d'alimentation par l'intermédiaire d'un transistor (35) MOS à canal n, dont la borne de grille est commandée par un signal servant à connecter et déconnecter le dispositif (D) comparateur.

8. Circuit de production de tension suivant l'une des revendications 1 à 7, caractérisé en ce que le dispositif (2) de production de tension comporte : un oscillateur (14) qui peut être connecté et déconnecté par un signal,
et un circuit (15) de pompe qui est commandé par l'oscillateur (14).

9. Circuit de production de tension suivant l'une des revendications 1 à 7, caractérisé en ce que le dispositif (70) de production de tension comporte:
un transistor (71) MOS dont la section drain-source est branchée entre le deuxième potentiel (VDD) d'alimentation et la borne (3) de la capacité de mémoire et dont la borne de grille est commandée par le signal de sortie du premier dispositif (6) comparateur.
